# EUROPEAN PATENT APPLICATION

(11) **EP 2 869 334 A1**
(43) Date of publication of application: **06.05.2015**
(21) Application number: 13810167.0
(22) Date of filing: 26.06.2013
(51) Int. Cl.: H01L 21/205

(54) **GAS SUPPLY UNIT FOR SUPPLYING MULTIPLE GASES, AND METHOD FOR MANUFACTURING SAME**

(30) Priority: 29.06.2012 KR 20120071417; 23.10.2012 KR 20120118119
(71) Applicant: TGO Tech. Corporation, Hwaseong-si, Gyeonggi-do 445-812 (KR)
(72) Inventor: LEE, Yoo Jin, Yongin-si Gyeonggi-do 448-170 (KR); YEON, Se Hun, Suwon-si Gyeonggi-do 442-831 (KR); KIM, Dong Jee, Seongnam-si Gyeonggi-do 463-909 (KR)
(74) Representative: Zardi, Marco
(86) International application number: PCT/KR2013/005654
(87) International publication number: WO 2014/003437

(57) **Abstract**

The present invention relates to a gas supplying unit for supplying multiple gases. According to one embodiment of the invention, there is provided a gas supplying unit for supplying multiple gases, comprising an outer pipe and at least one inner pipe positioned inside of the outer pipe, wherein a first process gas supplied to the inner pipe is jetted outwardly from the outer pipe through a plurality of first gas jet orifices, and a second process gas supplied to the outer pipe is jetted outwardly from the outer pipe through a plurality of second gas jet orifices.

## Description

### FIELD OF THE INVENTION

The present invention relates to a gas supplying unit for supplying multiple gases and a method for manufacturing the same.

### BACKGROUND

A light emitting diode (LED) refers to a semiconductor light-emitting device for converting electrical current into light, which has been widely used as a light source for image display in an electronic apparatus such as info-communications equipment. In particular, it is known that LEDs are highly efficient in converting electric energy into light energy in contrast with conventional lights such as incandescent or fluorescent lights, and can save up to 90% of energy. Thus, LEDs are widely recognized as devices that may replace fluorescent lights or incandescent light bulbs.

A process for manufacturing an LED device may be largely divided into an epitaxial process, a chip process and a package process. The epitaxial process refers to a process of epitaxially growing a compound semiconductor on a substrate. The chip process refers to a process of fabricating an epitaxial chip by forming an electrode in each portion of the epitaxially grown substrate. The package process refers to a process of connecting a lead to the fabricated epitaxial chip and packaging the chip such that light may be outwardly emitted as much as possible.

Among the above processes, the epitaxial process is most essential in determining luminous efficiency of the LED device. When a compound semiconductor is not epitaxially grown on the substrate, a defect may occur within a crystal and serve as a non-radiative center to reduce the luminous efficiency of the LED device.

For the epitaxial process, i.e. the process of forming a deposition film on a substrate, a liquid phase epitaxy (LPE) method, a vapor phase epitaxy (VPE), a molecular beam epitaxy (MBE) method, and a chemical vapor deposition (CVD) method are used, for example. In particular, a metal-organic chemical vapor deposition (MOCVD) method or a hydride vapor phase epitaxy (HVPE) method is mainly used among others.

When a deposition film is formed on a plurality of substrates using a conventional MOCVD or HVPE method, a process gas is usually supplied from a bottom or one side of a reaction chamber. However, since the process gas cannot be uniformly supplied onto the plurality of substrates in this case, there occurs a problem that a deposition film cannot be evenly formed on the plurality of substrates. Therefore, a problem is caused that high-efficiency LED devices of the same quality cannot be produced in large quantity, so that the productivity and efficiency of the process are reduced.

In addition, a nozzle for supplying a plurality of sources is used for the process, and thus it is essential to solve a problem such as clogging of the nozzle.

### SUMMARY OF THE INVENTION

The present invention has been contrived to solve all the above-mentioned problems of prior art, and one object of the invention is to provide a gas supplying unit capable of uniformly forming a deposition film on a plurality of substrates while solving a problem of clogging of a gas supplying section, and a method for manufacturing the same.

According to one aspect of the invention to achieve the above object, there is provided a gas supplying unit for supplying multiple gases, comprising an outer pipe and at least one inner pipe positioned inside of the outer pipe, wherein a first process gas supplied to the inner pipe is jetted outwardly from the outer pipe through a plurality of first gas jet orifices, and a second process gas supplied to the outer pipe is jetted outwardly from the outer pipe through a plurality of second gas jet orifices.

According to the invention, there are provided a gas supplying unit capable of uniformly forming a deposition film on a plurality of substrates, and a method for manufacturing the same.

Further, according to the invention, there are provided a gas supplying unit capable of solving a problem of clogging of a process gas supplying section, and a method for manufacturing the same.

### BRIEF DESCRIPTION OF THE DRAWINGS

FIG. 1 is a cross-sectional view illustrating the configuration of a deposition film forming apparatus according to one embodiment of the invention.
FIG. 2 illustrates a method for manufacturing a gas supplying unit for supplying multiple gases according to one embodiment of the invention.
FIG. 3 is a cross-sectional view illustrating the configuration of a gas supplying unit for supplying multiple gases according to one embodiment of the invention.
FIG. 4 illustrates a method for manufacturing a gas supplying unit for supplying multiple gases according to another embodiment of the invention.
FIG. 5 is a cross-sectional view illustrating the configuration of a gas supplying unit for supplying multiple gases according to another embodiment of the invention.

### DETAILED DESCRIPTION OF THE PREFERRED EMBODIMENTS

In the following detailed description of the present invention, references are made to the accompanying drawings that show, by way of illustration, specific embodiments in which the invention may be practiced. These embodiments are described in sufficient detail to enable those skilled in the art to practice the invention. It should be understood that the various embodiments of the invention, although different from each other, are not necessarily mutually exclusive. For example, specific shapes, structures and characteristics described herein may be implemented as modified from one embodiment to another without departing from the spirit and scope of the invention. Moreover, it should be understood that the locations or arrangements of individual elements within each of the disclosed embodiments may also be modified without departing from the spirit and scope of the invention. Accordingly, the following detailed description is not to be taken in a limiting sense, and the scope of the invention, if properly described, is limited only by the appended claims together with all equivalents thereof. In the drawings, like reference numerals refer to the same or similar functions throughout the several views.

Hereinafter, the configuration of the present invention will be described in detail with reference to the accompanying drawings.

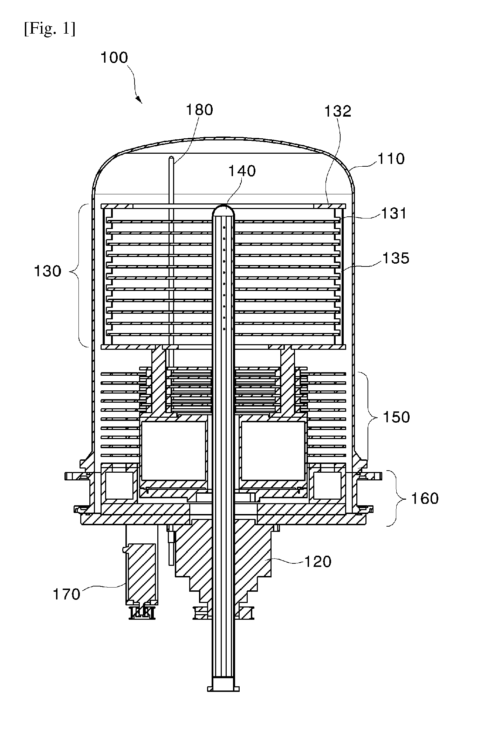

FIG. 1 is a cross-sectional view illustrating the configuration of a deposition film forming apparatus according to one embodiment of the invention.

First, the material of substrates (not illustrated) loaded in a deposition film forming apparatus 100 is not particularly limited, and substrates made of various materials such as glass, plastic, polymer, silicon wafer, stainless steel and sapphire may be loaded therein. Hereinafter, description will be made assuming that the substrates are circular sapphire substrates employed in the field of LEDs.

The deposition film forming apparatus 100 according to one embodiment of the invention may comprise a chamber 110. The chamber 110 is configured such that the inner space thereof is substantially sealed while a process is performed therein, and thus may function to provide a space in which a deposition film is formed on a plurality of substrates. The chamber 110 may be configured to maintain an optimum process condition, and may be manufactured in a rectangular or circular shape. The material of the chamber 110 is preferably quartz glass, but not limited thereto.

A process of forming the deposition film on the substrates is generally performed by supplying a deposition material to the inside of the chamber 110 and heating the inside of the chamber 110 to a temperature ranging from about 800°C to 1200°C. The deposition material supplied as above is supplied to the substrates to participate in forming the deposition film.

The deposition film forming apparatus 100 according to one embodiment of the invention may comprise a heater (not illustrated). The heater may be installed outside of the chamber 110 and function to apply heat required for the deposition process to the plurality of substrates. In order to facilitate growth of the deposition film on the substrates, the heater may heat the substrates to a temperature of about 1,200°C or higher. Although a heating method using a halogen lamp or an induction heating method may be used to heat the substrates, a resistance heating method may preferably be used. The resistance heating method refers to a heating method using an electric resistance to generate heat by flowing a current through a metallic resistance or a nonmetallic resistance such as silicon carbide.

The deposition film forming apparatus 100 according to one embodiment of the invention may comprise a substrate support unit 130. The substrate support unit 130 may comprise a plurality of substrate support plates 131, which may preferably be arranged in tiers. When the substrate support unit 130 comprises a plurality of substrate support plates 131 as above, the plurality of substrate support plates 131 may be arranged and fixed at regular intervals from each other by means of interval maintaining members 135. The number of the substrate support plates 131 may be variously changed depending on the purpose of using the present invention. The substrate support plates 131 and the interval maintaining members 135 is preferably made of quartz glass, but not limited thereto.

The deposition film forming apparatus 100 according to one embodiment of the invention may comprise a gas supplying unit 140. The gas supplying unit 140 may function to supply a process gas required for forming the deposition film to the inside of the chamber 110. The gas supplying unit 140 may be formed of quartz.

In a conventional deposition film forming apparatus, a gas supplying unit supplies a process gas from a bottom or one side of a chamber. Thus, it is unavoidable that a difference in the supplied amount of the process gas occurs between substrates positioned close to and far from the gas supplying unit. Consequently, such a difference causes a difference in the thickness of deposition films or the like, which results in failing to form deposition films of the same quality and size on a plurality of substrates.

In order to solve such a problem, the configuration of the present invention is characterized in that the gas supplying unit 140 is disposed to pass through the centers of the substrate support plates 131. In other words, the configuration of the present invention is characterized in that the gas supplying unit 140 passes through central through-holes (not illustrated) formed at the centers of the substrate support plates 131 to supply the process gas toward the plurality of substrates, which are supported by the substrate support plates 131 at the central portions of the substrate support plates 131. By employing this configuration in the present invention, the process gas may be uniformly supplied onto the plurality of substrates so that deposition films of the same quality and size can be formed on the plurality of substrates. The detailed configuration of the gas supplying unit 140 and a method for manufacturing the same will be described later.

The deposition film forming apparatus 100 according to one embodiment of the invention may comprise a baffle unit 150. The baffle unit 150 may be positioned at the bottom of the substrate support unit 130 to prevent heat generated in the chamber 110 from leaking outwardly. In particular, the baffle unit 150 may prevent the heat from leaking outwardly through a bottom supporting base 160.

The deposition film forming apparatus 100 according to one embodiment of the invention may comprise a bottom supporting base 160. The bottom supporting base 160 may be installed at the bottom of the chamber 110 to function to support the substrate support unit 130 and the baffle unit 150 while the deposition process is performed. A through-hole (not illustrated) may be formed at the center of the bottom supporting base 160 so that the gas supplying unit 140 passes therethrough. Exhaust orifices (not illustrated) may be formed on the opposite sides of the bottom supporting base 160 to exhaust the process gas outwardly.

A rotating unit 120 may be positioned under the bottom supporting base 160. The rotating unit 120 may enable rotation of the substrate support unit 130 and/or the gas supplying unit 140. When the rotating unit 120 rotates the substrate support unit 130 and/or the gas supplying unit 140, the process gas may be uniformly supplied to the substrates positioned on the substrate support plates 131.

A rotating power supply unit 170 may be positioned at one side under the bottom supporting base 160. The rotating power supply unit 170 may be a motor and may be connected with the rotating unit 120 via a power transmission means (not illustrated) such as a belt to rotate the rotating unit 120.

The deposition film forming apparatus 100 according to one embodiment of the invention may comprise a thermocouple 180. The thermocouple 180 may be inserted in one side of the bottom supporting base 160. The thermocouple 180 may be connected to a temperature control unit (not illustrated) and measure a temperature inside of the chamber 110 to control the temperature of the substrates.

Hereinafter, the gas supplying unit 140 according to one embodiment of the invention and a method for manufacturing the same will be described in detail.

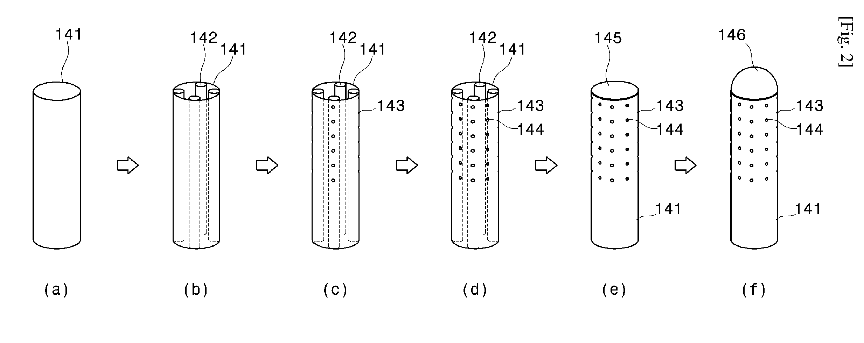

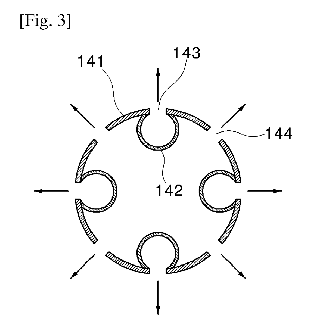

FIG. 2 illustrates a method for manufacturing a gas supplying unit 140 for supplying multiple gases according to one embodiment of the invention, and FIG. 3 is a cross-sectional view illustrating the configuration of the gas supplying unit 140 for supplying multiple gases according to one embodiment of the invention.

The gas supplying unit 140 for supplying multiple gases according to one embodiment of the invention may be in the shape of a dual pipe comprising an outer pipe 141 and at least one inner pipe 142 positioned inside of the outer pipe 141. The inner pipe 142 may be positioned to contact a predetermined portion of the outer pipe 141. Both the outer pipe 141 and the inner pipe 142 may be in the shape of a tube made of quartz. A first process gas and a second process gas may flow in the inner pipe 142 and the outer pipe 141, respectively. For example, the outer pipe 141 may be a passage through which GaCl gas and HCl gas (the second process gas) pass, and the inner pipe 142 may be a passage through which NH₃ gas (the first process gas) passes. Reactions may easily take place between NH₃ gas and GaCl gas and between NH₃ gas and HCl gas. According to the present embodiment, the first and second process gases which easily react with each other may be separately maintained in the inner pipe 142 and the outer pipe 141 until immediately before jetting of the process gases. Accordingly, no reaction is caused by the process gases within the gas supplying unit 140, so that a problem that a process gas jetting section is clogged by a reaction product may be avoided.

The gas supplying unit 140 may be formed with a plurality of first gas jet orifices 143 and a plurality of second gas jet orifices 144. The first gas jet orifices 143 may jet the first process gas supplied through the inner pipe 142, and the second gas jet orifices 144 may jet the second process gas supplied through the outer pipe 141. The positions where the first gas jet orifices 143 and the second gas jet orifices 144 are formed may respectively correspond to those of the plurality of substrate support plates 131. In addition, the sizes of the first gas jet orifices 143 and the second gas jet orifices 144 may vary depending on the positions where they are formed. Preferably, the sizes of the first gas jet orifices 143 and the second gas jet orifices 144 may increase as the positions where the first gas jet orifices 143 and the second gas jet orifices 144 are formed are farther from gas supply sources, i.e., along the direction in which the first and second process gases flow. As a result, the process gases may be uniformly supplied to the substrates 10 which are respectively positioned on the substrate support plates 131. Now, a method for manufacturing the gas supplying unit 140 according to one embodiment of the invention will be described below.

As illustrated in (a) of FIG. 2, the outer pipe 141 is prepared. Further, as illustrated in (b) of FIG. 2, a required number of the inner pipes 142 may be joined to predetermined portions within the outer pipe 141. The present embodiment illustrates that the number of the inner pipes 142 is four, but not limited thereto. The inner pipes 142 may be joined to the inside of the outer pipe 141 by various methods such as welding.

Further, as illustrated in (c) of FIG. 2, the first gas jet orifices 143 may be formed in the portions where the inner pipes 142 are joined to the inside of the outer pipe 141 to allow outward communication of the inner pipes 142. Accordingly, the gas flowing in the inner pipes 142 may be outwardly jetted through the first gas jet orifices 143. The number of the first gas jet orifices 143 is not specifically limited and may be variously changed depending on the purpose of using the present invention. In addition, as illustrated in (d) of FIG. 2, the second gas jet orifices 144 may be formed in the portions where the inner pipes 142 do not contact the outer pipe 141 (i.e., the portions other than the aforementioned predetermined portions) to allow outward communication of the outer pipe 141. Accordingly, the gas flowing in the outer pipe 141 may be outwardly jetted through the second gas jet orifices 144. The first gas jet orifices 143 and the second gas jet orifices 144 may be formed using various methods such as drilling.

Further, in order to prevent the process gases flowing inside of the gas supplying unit 140 from being discharged to any portions other than the first gas jet orifices 143 and the second gas jet orifices 144, a cover 145 may be laid to seal one end of the outer pipe 141 and the inner pipes 142 as illustrated in (e) of FIG. 2. In addition, a hemispheric cap 146 may be laid on the cover 145 as necessary, as illustrated in (f) of FIG. 2.

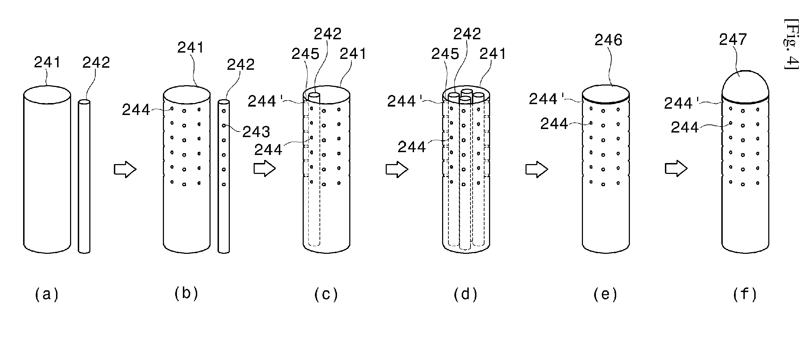

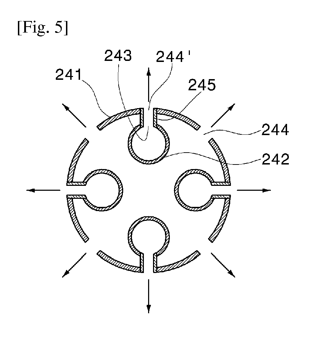

FIG. 4 illustrates a method for manufacturing a gas supplying unit 240 for supplying multiple gases according to another embodiment of the invention, and FIG. 5 is a cross-sectional view illustrating the configuration of the gas supplying unit 240 for supplying multiple gases according to another embodiment of the invention.

The gas supplying unit 240 for supplying multiple gases according to another embodiment of the invention may comprise an outer pipe 241 and an inner pipe 242, as in the previous embodiment. However, unlike the previous embodiment, the inner pipe 242 may not be directly joined to the outer pipe 241 in the gas supplying unit 240 according to the present embodiment. Both the outer pipe 241 and the inner pipe 242 may also be made of quartz in the present embodiment. The inner pipe 242 may be a passage through which a first process gas (NH₃ gas) passes, and the outer pipe 241 may be a passage through which a second process gas (GaCl gas and HCl gas) passes. Accordingly, as in the previous embodiment, no reaction is caused by the process gases within the gas supplying unit 240, so that a problem of clogging of a process gas jetting section may be avoided.

Further, the gas supplying unit 240 may be formed with a plurality of first gas jet orifices 244' and a plurality of second gas jet orifices 244. The first gas jet orifices 244' may jet the first process gas supplied through the inner pipe 242, and the second gas jet orifices 244 may jet the second process gas supplied through the outer pipe 241. However, the present embodiment is different from the previous one in that the first process gas supplied through the inner pipe 242 is jetted to third gas jet orifices 243, and the jetted first process gas is jetted to the first gas jet orifices 244' through a passage 245. In other respects, the present embodiment may be the same as the previous one in terms of the positions where the first and second gas jet orifices 244' and 244 are formed and the sizes of the first and second gas jet orifices 244' and 244. Now, a method for manufacturing the gas supplying unit 240 will be described below.

As illustrated in (a) of FIG. 4, the outer pipe 241 and the inner pipe 242 are prepared. Further, as illustrated in (b) of FIG. 4, the first and second gas jet orifices 244' and 244 may be formed in the outer pipe 241, and the third gas jet orifices 243 may be formed in the inner pipe 242. In the outer pipe 241, the first and second gas jet orifices 244' and 244 may be formed at equal intervals along a circumferential direction at each predetermined height. In the inner pipe 242, the third gas jet orifices 243 may be formed at each predetermined height in a row. Since the first gas jet orifices 244' in the outer pipe 241 and the third gas jet orifices 243 in the inner pipe 242 are connected with each other as will be described below, the heights at which the first gas jet orifices 244' and the third gas jet orifices 243 are formed are preferably the same as each other.

When the first and second gas jet orifices 244' and 244 are formed in the outer pipe 241 and the third gas jet orifices 243 are formed in the inner pipe 242, the passage 245 may be formed between the first gas jet orifices 244' formed in the outer pipe 241 and the third gas jet orifices 243 formed in the inner pipe 242, as illustrated in (c) of FIG. 4. In (d) of FIG. 4, it is illustrated that all the inner pipes 242 are positioned inside of the outer pipe 241, and the third gas jet orifices 243 in the inner pipe 242 are connected with the first gas jet orifices 244' in the outer pipe 241.

When the first gas jet orifices 244' and the third gas jet orifices 243 are all connected by means of the passage 245, a cover 246 may be laid to seal one end of the outer pipe 241 and the inner pipes 242 as illustrated in (e) of FIG. 4, in order to prevent the process gases flowing inside of the gas supplying unit 240 from being discharged to any portions other than the first gas jet orifices 244' and the second gas jet orifices 244. In addition, a hemispheric cap 247 may be laid on the cover 246 as necessary, as illustrated in (f) of FIG. 4.

Although the present invention has been illustrated and described above with reference to preferred embodiments, the present invention is not limited to the above-described embodiments, and various modifications and changes may be made by those skilled in the art to which the present invention pertains without departing from the spirit of the invention. It should be noted that such modifications and changes will fall within the scope of the present invention as defined in the appended claims.

### DESCRIPTION OF REFERENCE NUMERAL

- 140, 240:: gas supplying unit
- 141, 241:: outer pipe
- 142, 242:: inner pipe
- 143, 244':: first gas jet orifice
- 144, 244:: second gas jet orifice
- 243:: third gas jet orifice
- 245:: passage

## Claims

1. A gas supplying unit for supplying multiple gases, comprising:
an outer pipe; and
at least one inner pipe positioned inside of the outer pipe,
wherein a first process gas supplied to the inner pipe is jetted outwardly from the outer pipe through a plurality of first gas jet orifices, and
a second process gas supplied to the outer pipe is jetted outwardly from the outer pipe through a plurality of second gas jet orifices.

2. The gas supplying unit of Claim 1, wherein the inner pipe contacts a predetermined portion of the outer pipe,
the first gas jet orifices are formed in the predetermined portion to pass through the outer pipe and the inner pipe, and
the second gas jet orifices are formed in a portion other than the predetermined portion of the outer pipe.

3. The gas supplying unit of Claim 1, wherein a plurality of third gas jet orifices are formed in the inner pipe, and
a passage is interposed between the first gas jet orifices and the third gas jet orifices.

4. The gas supplying unit of Claim 2 or 3, wherein the positions where the plurality of first gas jet orifices and the plurality of second gas jet orifices are formed correspond to the positions where substrates to be processed by the process gases are laid.

5. The gas supplying unit of Claim 2 or 3, wherein the first process gas and the second process gas are different from each other.

6. The gas supplying unit of Claim 5, wherein the first process gas is NH₃ gas and the second process gas is HCl gas and GaCl gas.

7. The gas supplying unit of Claim 2 or 3, wherein the sizes of the first gas jet orifices or the second gas jet orifices are different depending on the positions where they are formed.

8. The gas supplying unit of Claim 7, the sizes of the first gas jet orifices or the second gas jet orifices are increased along a direction in which the first process gas or the second process gas flows.

9. The gas supplying unit of Claim 2 or 3, wherein the outer pipe and the inner pipe are made of quartz.

10. A method for manufacturing a gas supplying unit for supplying multiple gases, comprising the steps of:
joining at least one inner pipe to a predetermined portion of an outer pipe;
forming a first gas jet orifice to pass through the outer pipe and the inner pipe in the predetermined portion of the outer pipe;
forming a second gas jet orifice in a portion other than the predetermined portion of the outer pipe; and
laying a cover on one end of the outer pipe and the inner pipe.

11. The method of Claim 10, wherein the inner pipe is joined to the predetermined portion of the outer pipe using a welding technique.

12. The method of Claim 10, wherein the first gas jet orifice and the second gas jet orifice are formed using a drill.

13. A method for manufacturing a gas supplying unit for supplying multiple gases, comprising the steps of:
forming a first gas jet orifice and a second gas jet orifice in an outer pipe;
forming a third gas jet orifice in an inner pipe;
positioning at least one inner pipe inside of the outer pipe and interposing a passage between the first gas jet orifice and the third gas jet orifice; and
laying a cover on one end of the outer pipe and the inner pipe.

14. The method of Claim 13, wherein the passage is interposed between the first gas jet orifice and the third gas jet orifice using a welding technique.

15. The method of Claim 13, wherein the first gas jet orifice, the second gas jet orifice and the third gas jet orifice are formed using a drill.
